# EUROPEAN PATENT APPLICATION

(11) **EP 4 579 339 A2**
(43) Date of publication of application: **02.07.2025**
(21) Application number: 24223494.6
(22) Date of filing: 27.12.2024
(51) Int. Cl.: G03F 7/00, G03F 7/004, G03F 7/032, G03F 7/075

(54) **PIXEL DEFINE LAYER**

(30) Priority: 29.12.2023 KR 20230197751
(71) Applicant: Duksan Neolux Co., Ltd, Cheonan-si, Chungcheongnam-do (KR)
(72) Inventor: BAE, Jun, Cheonan-si, Chungcheongnam-do (KR); LEE, Changmin, Cheonan-si, Chungcheongnam-do (KR); LEE, Yeon Soo, Cheonan-si, Chungcheongnam-do (KR); KIM, Jin Hyun, Cheonan-si, Chungcheongnam-do (KR); MUN, Soung Yun, Cheonan-si, Chungcheongnam-do (KR); KIM, Kyung Soo, Cheonan-si, Chungcheongnam-do (KR)
(74) Representative: BCKIP Part mbB

(57) **Abstract**

The present disclosure is to not only ensure vivid colors but also increase display reliability and lifespan by implementing a pixel defining layer having a low outgas amount on an electrode substrate by using a photosensitive composition including a leveling agent that does not contain fluorine; and a resin. In other words, if the amount of outgas in a panel after post-heat treatment is 15 ppm or more, it may cause a decrease in luminance and a decrease in lifespan due to pixel shrinkage, and if the contact angle with water is 100 degrees (°) or more, peeling of the deposit may occur while the surface energy is lowered.

## Description

### CROSS REFERENCE TO RELATED APPLICATION

This application claims the benefit of priority on Korean Patent Application No. 10-2023-0197751, filed on December 29, 2023 at the Korean Intellectual Property Office.

### BACKGROUND

### Field

The present disclosure relates to a pixel defining layer of a light-emitting display device using a photosensitive composition.

### Related Art

As a flat panel display device, a liquid crystal display device (LCD), an organic light-emitting display device (OLED), *etc.* are widely used. Among these, the organic light-emitting display device has advantages such as low power consumption, a fast response speed, high color reproducibility, high luminance, and a wide viewing angle.

In the case of the organic light-emitting display device, a polarizing film is used to block the light being reflected from the panel when external light is incident, and there is a disadvantage in that the polarizing film is not suitable for application to a flexible device due to a lack of bending properties.

As a method for solving the above problem, methods such as forming an inorganic film for blocking light on an upper substrate as well as a color filter and a black matrix have been proposed. However, these methods have limitations in obtaining a desired level of antireflection effect, and no specific methods for replacing the polarizing film have yet been suggested.

Meanwhile, colored patterns are used as red, green, and blue color filters not only in liquid crystal displays but also in organic light emitting displays.

When producing the coloring patterns, carbon black and inorganic pigments as well as various types of organic pigments are used as colorants, pigment dispersions in which these colorants are dispersed are mixed with other compositions to form patterns.

Organic light-emitting displays made from pixels formed in this way can implement more vivid colors. The patterns using the above coloring compositions use a small amount of a leveling agent in order to ensure good coating over a large area, and the main component is a fluorine series, which has the best characteristics. However, its use is currently restricted due to regulations on fluorine compounds (PFAS), and the use of a non-fluorine-based alternative additive is inevitable. The alternative additive may have lower characteristics compared to the fluorine-based one, which may result in large amounts in filter pressure difference in the process or contact angle in the pattern, flatness of the coating film, and outgas. If the outgas is large, problems such as pixel shrinkage, dark spots, and electrode oxidation may occur, which reduces the lifespan and luminance of the organic light-emitting display.

### SUMMARY

In order to solve the problems of the related art, one embodiment of the present disclosure is to not only ensure vivid colors but also increase display reliability and lifespan by implementing a pixel defining layer containing a resin having a low contact angle, a low coating film flatness, and a low outgas amount at the same content as the conventional fluorine-based one on an electrode substrate by using a leveling agent that does not contain fluorine.

That is, an object of the present disclosure is to develop a photosensitive resin composition in which the contact angle on the panel after post-heat treatment satisfies 60° to 100°, the pattern thickness is managed to be 2.0 µm or less within the substrate, and the outgas amount is 15 ppm or less. Since it may cause a decrease in luminance and a decrease in lifespan due to pixel shrinkage if the outgas amount is 15 ppm or more, it is an object of the present disclosure to minimize the generation of outgas in the panel state by generating sufficient fume in the post-heat treatment step in order to minimize the amount of outgas after the post-heat treatment process is finished.

Another embodiment is to provide an organic light-emitting display device including the pixel defining layer prepared by the above method.

Still another embodiment is to provide an electronic device including the organic light-emitting display device.

It is preferable that a pixel defining layer according to the present disclosure contains a photosensitive composition including a resin; and a leveling agent that does not contain fluorine.

It is preferable that the leveling agent includes a silicone-based compound.

It is preferable that the silicone-based compound has a molecular weight of 5,000 g/mol to 15,000 g/mol.

It is more preferable that the silicone-based compound has a molecular weight of 5,000 g/mol to 10,000 g/mol.

It is preferable that the silicone-based compound has a viscosity of 100,000 mm²/s to 500,000 mm²/s.

It is more preferable that the silicone-based compound has a viscosity of 10 mm²/s to 40 mm²/s when a mixture of 50% by weight of the silicone-based compound and 50% by weight of propylene glycol methyl ether acetate was measured at 20°C conditions.

It is more preferable that the mixture of the silicone-based compound has a viscosity of 10 mm²/s to 30 mm²/s.

It is preferable that the silicone-based compound contains a substituent selected from the group consisting of: a C₁-C₄₀ alkyl group; a C₁-C₄₀ alkenyl group; a C₁-C₄₀ alkynyl group; a C₁-C₄₀ alkoxy group; a C₆-C₄₀ aryloxy group; a C₁-C₄₀ alkoxycarbonyl group; a carbonyl group; an ether group; an ester group; a carboxyl group, or combinations thereof.

It is preferable that the pixel defining layer is composed of a single layer.

It is preferable that the photosensitive composition includes a leveling agent that does not contain 0.01 to 0.5% by weight of fluorine based on the total amount of the photosensitive composition.

It is preferable that the resin includes an acrylic binder resin; a cardo-based binder resin; or a combination thereof.

It is preferable that the acrylic binder resin has a weight average molecular weight of 3,000 g/mol to 150,000 g/mol.

It is preferable that the cardo-based binder resin contains a repeating structure of Formula 1 below. 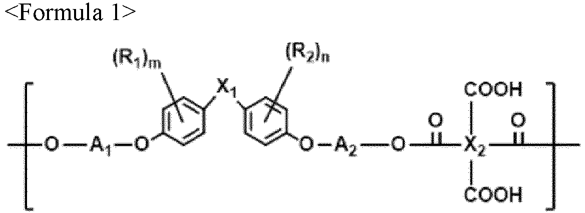 In Formula 1,
1) R₁ and R₂ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
2) R₁ and R₂ can form a ring between neighboring groups,
3) m and n are each independently an integer of 0 to 4,
4) A₁ and A₂ are each independently Formula 2 or Formula 3 below,

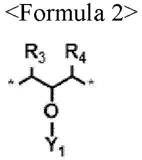

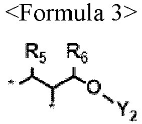

In Formula 2 and Formula 3,
4-1) * indicates a connection part,
4-2) R₃ to R₆ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-3) R₃ to R₆ can form a ring between neighboring groups,
4-4) Y₁ and Y₂ are each independently Formula 6 or Formula 7 below,

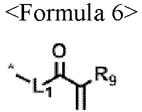

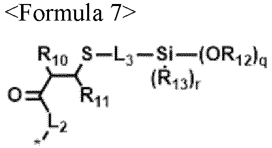

In Formula 6 and Formula 7,
4-4-1) * indicates a binding position,
4-4-2) R₉ is hydrogen or methyl,
4-4-3) R₁₀ to R₁₃ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-4-4) L₁ to L₃ are each independently a single bond; a fluorenylene group; C₂-C₃₀ alkylene; C₆-C₃₀ arylene; C₂-C₃₀ heterocycle; C₁-C₃₀ alkoxylene; C₂-C₃₀ alkyleneoxy; a C₆-C₃₀ aryloxy group; or a C₂-C₃₀ polyethyleneoxy group,
4-4-5) q and r are each independently an integer of 0 to 3; with the proviso that q+r = 3, and
5) the ratio of A₁ and A₂ in the polymer chain of the resin including a repeating unit represented by Formula 1 is 9:1 to 1:9,
6) X₁ is a single bond; O; CO; SO₂; CR'R"; SiR'R"; Formula 4; or Formula 5 below,
6-1) R' and R" are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-2) R' and R" can form a ring between adjacent groups,

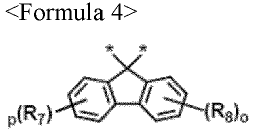

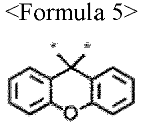

In Formula 4 and Formula 5,
6-3) * indicates a binding position,
6-4) R₇ and R₈ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-5) o and p are each independently an integer of 0 to 4,
7) X₂ is a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenylene group; a carbonyl group; an ether group; or a C₁-C₂₀ alkoxycarbonyl group, and
8) R', R", X₂, L₁ to L₃, R₁ to R₈, and R₁₀ to R₁₃ can each be further substituted with one or more substituents selected from the group consisting of deuterium; a halogen; a silane group substituted or unsubstituted with a C₁-C₃₀ alkyl group or C₆-C₃₀ aryl group; a siloxane group; a boron group; a germanium group; a cyano group; an amino group; a nitro group; a C₁-C₃₀ alkylthio group; a C₁-C₃₀ alkoxy group; a C₆-C₃₀ arylalkoxy group; a C₁-C₃₀ alkyl group; a C₂-C₃₀ alkenyl group; a C₂-C₃₀ alkynyl group; a C₆-C₃₀ aryl group; a C₆-C₃₀ aryl group substituted with deuterium; a fluorenyl group; a C₂-C₃₀ heterocyclic group containing at least one heteroatom selected from the group consisting of O, N, S, Si, and P; a C₃-C₃₀ alicyclic group; a C₇-C₃₀ arylalkyl group; a C₈-C₃₀ arylalkenyl group; and combinations thereof, and can form a ring between adjacent substituents.

It is preferable that the cardo-based resin has a weight average molecular weight of 1,000 to 100,000 g/mol.

It is preferable that the cardo-based resin is contained in an amount of 1 to 30% by weight based on the total amount of the photosensitive composition.

It is preferable that the photosensitive composition includes a colorant.

It is preferable that the colorant includes one or more of an inorganic dye, an organic dye, an inorganic pigment, and an organic pigment.

It is preferable that the colorant is contained in an amount of 1 to 40% by weight based on the total amount of the photosensitive composition.

It is preferable that the colorant is pretreated using a dispersant; or a water-soluble inorganic salt and a wetting agent.

It is preferable that the colorant has an average particle diameter of 20 nm to 110 nm.

It is preferable that the photosensitive composition includes a reactive unsaturated compound.

It is preferable that the photosensitive composition includes 1 to 40% by weight of a reactive unsaturated compound based on the total amount of the photosensitive composition.

It is preferable that the photosensitive composition includes a photoinitiator.

It is preferable that the photosensitive composition includes 0.01 to 10% by weight of a photoinitiator based on the total amount.

It is preferable that the pixel defining layer preferably has a contact angle with the interface of 60° to 100° when 2 to 10 microliters (*µℓ*) of water is brought into contact with the surface under temperature conditions of 25±3°C.

It is more preferable that the contact angle with the interface is 65° to 95°.

It is preferable that the pixel defining layer is free of residue.

It is preferable that the pixel defining layer is prepared by including steps of performing a post-heat treatment on a photosensitive composition including a leveling agent that does not contain fluorine.

It is preferable that the post-heat treatment step is performed at a temperature of 210°C to 300°C for 30 to 120 minutes.

It is preferable that the amount of outgas generated after the post-heat treatment step is 15 ppm or less.

It is preferable that the pixel defining layer is prepared by further including the steps of applying and coating a photosensitive composition; performing pre-bake; performing exposure; and performing development.

It is preferable that the temperature of the pre-bake step is 80°C to 150°C.

It is preferable that the pre-bake step is performed for 50 to 200 seconds.

It is preferable that an active line of 20 mJ/cm² to 350 mJ/cm² is irradiated in the exposure step.

It is more preferable that an active line of 20 mJ/cm² to 150 mJ/cm² is irradiated in the exposure step.

It is preferable that the post-heat treatment step is performed at a temperature of 210°C to 300°C.

It is more preferable that the temperature of the post-heat treatment step is 250°C to 270°C.

It is preferable that the post-heat treatment step is performed for 30 to 120 minutes.

It is more preferable that the post-heat treatment step is performed 60 to 120 minutes.

It is preferable that the amount of outgas generated after the post-heat treatment step is 15 ppm or less.

It is preferable that the pixel defining layer after the post-heat treatment step has a thickness of 1.40 µm to 1.60 µm.

It is more preferable that the pixel defining layer has a thickness of 1.45 µm to 1.55 µm.

In still another embodiment, it is preferable that the present disclosure provides an organic light-emitting display device including the pixel defining layer.

In still another embodiment, it is preferable that the present disclosure provides an electronic device including: the display device; and a control unit for driving the display device.

### Effect of invention

The present disclosure is to implement a pixel defining layer having a low outgas amount to a level equivalent to that of existing fluorine-based additives on an electrode substrate by applying a leveling agent that does not contain fluorine, and to not only ensure vivid colors but also increase display reliability and lifespan by satisfying an equivalent level of contact angle and flatness. In other words, if the contact angle after post-heat treatment is 100° or more, the surface energy decreases to decrease the adhesive force between the substrate and the interface, which may cause film peeling in the deposition process of the pattern and the organic light-emitting material, and if the amount of outgas in the panel is 15 ppm or more, this may cause a decrease in luminance and a decrease in lifespan due to pixel shrinkage. Therefore, the contact angle and the amount of outgas after the post-heat treatment process is completed are minimized by including an appropriate additive according to the present disclosure.

### BRIEF DESCRIPTION OF THE DRAWING

FIG. 1 schematically illustrates an organic light-emitting display device and a pixel defining layer of the present disclosure.
FIG. 2 schematically illustrates contact angles with water of Comparative Examples and Examples by photographing them.
FIG. 3 schematically illustrates surfaces of the pixel defining layers of Comparative Examples and Examples by photographing them.

### DESCRIPTION OF EXEMPLARY EMBODIMENTS

Hereinafter, some embodiments of the present disclosure will be described in detail with reference to exemplary drawings. In adding reference numerals to components of each drawing, the same components may have the same reference numerals as far as possible even though they are indicated in different drawings.

When it is determined that a detailed description of a related known constitution or function may obscure the gist of the present disclosure in describing the present disclosure, the detailed description thereof may be omitted. When the expressions "includes", "has", "consisting of", *etc.* mentioned in this specification are used, other parts may be added unless "only" is used. When a component is expressed in the singular form, it may include a case in which the plural form is included unless otherwise explicitly stated.

In addition, in describing the components of the present disclosure, terms such as first, second, A, B, (a), (b), etc. may be used. Such terms are only for distinguishing the components from other components, and the essence, order, sequence, number, or etc. of the relevant components are not limited by the terms.

In the description of the positional relationship of the components, when two or more components are described as being "connected", "linked", or "fused", etc., the two or more components may be directly "connected", "linked", or "fused", but it should be understood that the two or more components may also be "connected", "linked", or "fused" by way of a further "interposition" of a different component. Here, the different component may be included in any one or more of the two or more components that are to be "connected", "linked", or "fused" to each other.

In addition, when a component such as a layer, a film, a region, a plate, or *etc.* is described to be "on top" or "on" of another component, it should be understood that this may not only include a case where the component is "immediately on top of" another component, but also include a case where another component is disposed therebetween. In contrast, it should be understood that when a component is described to be "immediately on top of" another part, this may mean that there is not another part disposed therebetween.

In the description of the temporal flow relationship relating to the components, the operation method, or the preparation method, for example, when the temporal precedence or flow precedence is described by way of "after", "subsequently", "thereafter", "before", *etc.,* it may also include cases where the flow is not continuous unless terms such as "immediately" or "directly" are used.

Meanwhile, when the reference is made to numerical values or corresponding information for components, numerical values or corresponding information may be interpreted as including an error range that may occur due to various factors (e.g., process factors, internal or external shocks, noise, etc.) even if a separate explicit description is not present.

The terms used in this specification and the appended claims are as follows unless otherwise stated without departing from the spirit of the present disclosure.

The term used in this application "halo" or "halogen" includes fluorine (F), chlorine (Cl), bromine (Br), and iodine (I) unless otherwise specified.

The term used in this application "alkyl" or "alkyl group" refers to a radical of saturated aliphatic functional groups having 1 to 60 carbons linked by a single bond unless otherwise specified, and including a linear chain alkyl group, a branched chain alkyl group, a cycloalkyl (alicyclic) group, an alkyl-substituted cycloalkyl group, and a cycloalkyl-substituted alkyl group.

The term used in this application "haloalkyl group" or "halogenalkyl group" refers to an alkyl group in which a halogen is substituted unless otherwise specified.

The term used in this application "alkenyl" or "alkynyl", unless otherwise specified, has a double bond or triple bond, respectively, includes a linear or branched chain group, and has 2 to 60 carbon atoms, but is not limited thereto.

The term used in this application "cycloalkyl" refers to alkyl which forms a ring having 3 to 60 carbon atoms unless otherwise specified, but is not limited thereto.

The term used in this application "alkoxy group" or "alkyloxy group" refers to an alkyl group to which an oxygen radical is bonded, and has 1 to 60 carbon atoms unless otherwise specified, but is not limited thereto.

The term used in this application "alkenoxyl group", "alkenoxy group", "alkenyloxyl group", or "alkenyloxy group" refers to an alkenyl group to which an oxygen radical is attached, and has 2 to 60 carbon atoms unless otherwise specified, but is not limited thereto.

The term used in this application "aryl group" and "arylene group" each have 6 to 60 carbon atoms unless otherwise specified, but are not limited thereto. The aryl group or arylene group in this application includes monocyclic compounds, ring assemblies, multiple fused cyclic compounds, etc. For example, the aryl group may include a phenyl group, a monovalent functional group of biphenyl, a monovalent functional group of naphthalene, a fluorenyl group, and a substituted fluorenyl group, and the arylene group may include a fluorenylene group and a substituted fluorenylene group.

The term used in this application "ring assemblies" means that two or more ring systems (monocyclic or fused ring systems) are directly connected to each other through a single bond or double bond, and the number of direct links between such rings is one less than the total number of ring systems contained in the compound. In the ring assemblies, the same or different ring systems may be directly connected to each other through a single bond or double bond.

Since the aryl group in this application includes ring assemblies, the aryl group includes biphenyl and terphenyl in which a benzene ring, which is a single aromatic ring, is connected by a single bond. In addition, since the aryl group also includes a compound in which an aromatic ring system fused to an aromatic single ring is connected by a single bond, it also includes, for example, a compound in which a benzene ring, which is an aromatic single ring, and fluorine, which is a fused aromatic ring system, are linked by a single bond.

The term used in this application "multiple fused ring systems" refers to a fused ring form in which at least two atoms are shared, and it includes a form in which ring systems of two or more hydrocarbons are fused, a form in which at least one heterocyclic system including at least one heteroatom is fused, *etc.* Such multiple fused ring systems may be an aromatic ring, a heteroaromatic ring, an aliphatic ring, or a combination of these rings. For example, in the case of an aryl group, it may be a naphthalenyl group, a phenanthrenyl group, a fluorenyl group, *etc.,* but is not limited thereto.

The term used in this application "a spiro compound" has "a spiro union", and the spiro union refers to a linkage in which two rings are formed by sharing only one atom. At this time, the atom shared by the two rings is called a "spiro atom", and they are each called "monospiro-", "dispiro-", and "trispiro-" compounds depending on the number of spiro atoms included in a compound.

The terms used in this application "fluorenyl group", "fluorenylene group", and "fluorenetriyl group" refer to a monovalent, divalent, or trivalent functional group in which R, R', R", and R‴ are all hydrogen in the following structures, respectively, unless otherwise specified, "substituted fluorenyl group", "substituted fluorenylene group", or "substituted fluorenetriyl group" means that at least one of the substituents R, R', R", and R‴ is a substituent other than hydrogen, and cases where R and R' are bound to each other to form a spiro compound together with carbon to which they are linked are included. In this specification, all of the fluorenyl group, the fluorenylene group, and the fluorenetriyl group may also be referred to as a fluorene group regardless of valences such as monovalent, divalent, trivalent, *etc.*

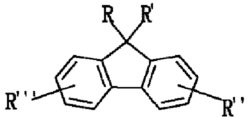

In addition, R, R', R", and R‴ may each independently be an alkyl group having 1 to 20 carbon atoms, an alkenyl group having 1 to 20 carbon atoms, an aryl group having 6 to 30 carbon atoms, and a heterocyclic group having 2 to 30 carbon atoms and, for example, the aryl group may be phenyl, biphenyl, naphthalene, anthracene, or phenanthrene, and the heterocyclic group may be pyrrole, furan, thiophene, pyrazole, imidazole, triazole, pyridine, pyrimidine, pyridazine, pyrazine, triazine, indole, benzofuran, quinazoline, or quinoxaline. For example, the substituted fluorenyl group and the fluorenylene group may each be a monovalent functional group or divalent functional group of 9,9-dimethylfluorene, 9,9-diphenylfluorene, and 9,9'-spirobi [9H-fluorene] .

The term used in this application "heterocyclic group" includes not only an aromatic ring such as "heteroaryl group" or "heteroarylene group", but also a non-aromatic ring, and refers to a ring having 2 to 60 carbon atoms each including one or more heteroatoms unless otherwise specified, but is not limited thereto. The term used in this application "heteroatom" refers to N, O, S, P, or Si unless otherwise specified, and the heterocyclic group refers to a monocyclic group including a heteroatom, ring assemblies, multiple fused ring systems, spiro compounds, *etc.*

For example, the "heterocyclic group" may also include a compound including a heteroatom group such as SO₂, P=O, *etc.* such as the compound shown below, instead of carbon that forms a ring.

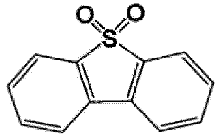

The term used in this application "ring" includes monocyclic and polycyclic rings, includes heterocycles containing at least one heteroatom as well as hydrocarbon rings, and includes aromatic and non-aromatic rings.

The term used in this application "polycyclic" includes ring assemblies such as biphenyl, terphenyl, *etc.,* multiple fused ring systems, and spiro compounds, includes non-aromatic as well as aromatic compounds, and includes heterocycles containing at least one heteroatom as well as hydrocarbon rings.

The term used in this application "alicyclic group" refers to cyclic hydrocarbons other than aromatic hydrocarbons, includes monocyclic compounds, ring assemblies, multiple fused ring systems, spiro compounds, *etc.,* and refers to a ring having 3 to 60 carbon atoms unless otherwise specified, but is not limited thereto. For example, even when benzene, which is an aromatic ring, and cyclohexane, which is a non-aromatic ring, are fused, the alicyclic group corresponds to an aliphatic ring.

In addition, when prefixes are named consecutively, it means that the substituents are listed in the order they are described. For example, in the case of an arylalkoxy group, it means an alkoxy group substituted with an aryl group, in the case of an alkoxycarbonyl group, it means a carbonyl group substituted with an alkoxy group, and further in the case of an arylcarbonyl alkenyl group, it means an alkenyl group substituted with an arylcarbonyl group, wherein the arylcarbonyl group is a carbonyl group substituted with an aryl group.

In addition, unless otherwise explicitly specified, "substituted" in the term used in this application "substituted or unsubstituted" refers to a substitution with one or more substituents selected from the group consisting of deuterium, a halogen, an amino group, a nitrile group, a nitro group, a C₁-C₃₀ alkyl group, a C₁-C₃₀ alkoxy group, a C₁-C₃₀ alkylamine group, a C₁-C₃₀ alkylthiophene group, a C₆-C₃₀ arylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryl group substituted with deuterium, a C₈-C₃₀ arylalkenyl group, a silane group, a boron group, a germanium group, and a C₂-C₂₀ heterocyclic group containing at least one heteroatom selected from the group consisting of O, N, S, Si, and P, but is not limited to these substituents.

Although the "names of functional groups" corresponding to the aryl group, arylene group, heterocyclic group, etc. exemplified as examples of each symbol and a substituent thereof in this application may be described as "names of the functional groups reflecting their valences", they may also be described as the "names of their parent compounds". For example, in the case of "phenanthrene", which is a type of an aryl group, the names of the groups may also be described such that the monovalent "group" is divided and described as "phenanthryl (group)", and the divalent 'group' is divided and described as "phenanthrylene (group)", etc., but may also be described as "phenanthrene", which is the name of its parent compound regardless of its valence.

Similarly, in the case of pyrimidine as well, it may be described as "pyrimidine" regardless of its valence, or it may also be described as the "name of the group" of the relevant valence such as pyrimidinyl (group) in the case of monovalent and pyrimidinylene (group) in the case of divalent. Therefore, when the type of a substituent in this application is described as the name of its parent compound, it may refer to an n-valent "group" formed by detachment of a hydrogen atom bonded to a carbon atom and/or hetero atom of its parent compound.

In addition, in describing the names of the compounds or the substituents in this specification, the numbers, alphabets, *etc.* indicating positions may be omitted. For example, pyrido[4,3-d]pyrimidine may be described as pyridopyrimidine, benzofuro[2,3-d]pyrimidine may be described as benzofuropyrimidine, and 9,9-dimethyl-9H-fluorene may be described as dimethylfluorene. Therefore, both benzo[g]quinoxaline and benzo[f]quinoxaline may be described as benzoquinoxaline.

In addition, unless there is an explicit description, the formulas used in this application are applied in the same manner as in the definition of substituents by the exponent definition of the formula below.

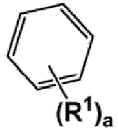

Here, when a is an integer of 0, it means that the substituent R1 is not present, that is, when a is 0, it means that hydrogen is bonded to all carbons that form a benzene ring, and at this time, the indication of hydrogen bonded to carbons may be omitted, and the formula or compound may be described. In addition, when a is an integer of 1, one substituent R¹ may be bonded to any one of carbons forming a benzene ring, when a is an integer of 2 or 3, it may be bonded, for example, as shown below, even when a is an integer of 4 to 6, it may be bonded to carbons of a benzene ring in a similar manner, and when a is an integer of 2 or more, R¹ may be the same as or different from each other.

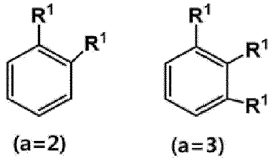

Unless otherwise specified in the present application, forming a ring means that adjacent groups bind to one another to form a single ring or multiple fused rings, and the single ring and the formed multiple fused rings may include a heterocycle containing at least one heteroatom as well as a hydrocarbon ring, and include aromatic and non-aromatic rings.

In addition, unless otherwise specified in this specification, when indicating a condensed ring, the number in "number-condensed ring" indicates the number of rings to be condensed. For example, a form in which three rings such as anthracene, phenanthrene, benzoquinazoline, *etc.* are condensed with one another may be marked as a 3-condensed ring.

Meanwhile, the term used in this application "bridged bicyclic compound" refers to a compound in which two rings share 3 or more atoms to form a ring unless otherwise specified. At this time, the shared atoms may include carbon or a hetero atom.

An organic electronic device in this application may refer to a component(s) between a positive electrode and a negative electrode, or may refer to an organic light-emitting diode which includes a positive electrode, a negative electrode, and a component(s) positioned therebetween.

In addition, in some cases, the display device in this application may refer to an organic electronic device, an organic light-emitting diode, and a panel including the same, or may refer to an electronic device including a panel and a circuit. Here, for example, the electronic device may include all of a lighting device, a solar cell, a portable or mobile terminal (*e.g*., a smart phone, a tablet, a PDA, an electronic dictionary, a PMP, *etc.*)*,* a navigation terminal, a game machine, various TV sets, various computer monitors, *etc.,* but is not limited thereto, and may be any type of device as long as it includes the component(s).

In another embodiment, a pixel defining layer prepared using the aforementioned photosensitive composition may be patterned on the pixel separation part of the organic light-emitting display device.

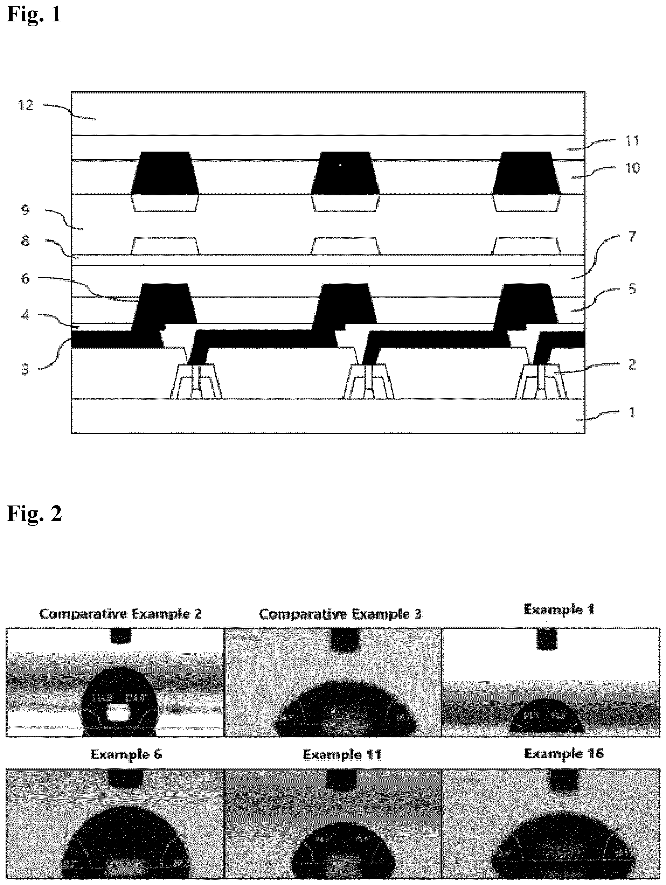

Hereinafter, if the organic light-emitting display device is described by referring to FIG. 1, the organic light-emitting display device according to the embodiment of the present disclosure may include a substrate 1, a TFT layer 2 on the substrate, a flat layer 3 on the TFT layer, a pixel electrode 4 on the flat layer, an organic light-emitting layer 5 on the pixel electrode, a counter electrode 7 disposed on the organic light-emitting layer, a sealing layer 8 disposed on the counter electrode, a touch panel 9 disposed on the sealing layer, a color filter 10 disposed on the touch panel, an OCA layer 11 disposed on the color filter, and a cover glass layer 12 disposed on the OCA layer.

The pixel defining layer 6 according to the present disclosure is preferably formed on the pixel electrode 4.

The pixel defining layer 6 may not only make the color vivid but also increase the reliability and lifespan of the organic light-emitting display device by applying a leveling agent that does not contain fluorine, thereby implementing a coloring pattern with a low contact angle, low coating film flatness, and a low outgas amount at the same content as conventional fluorine-based materials on the electrode substrate.

Hereinafter, embodiments of the present disclosure will be described in detail. However, these embodiments are presented as examples, and the present disclosure is not limited thereby, and the present disclosure is only defined by the scope of the claims to be described later.

The photosensitive composition according to one embodiment of the present disclosure may be used to prepare a pixel defining layer, a red pattern, a green pattern, a blue pattern, or a black matrix.

A black pixel defining layer (PDL) according to one embodiment of the present disclosure may further contain an organic black pigment or black dye as an additional coloring material other than a coloring material contained in the colorant described above. For example, an organic pigment may be used alone, or a mixture of an organic pigment and a coloring pigment may be used. At this time, there is an advantage in that the strength of the film (layer) or the adhesion to the substrate is not reduced even when the amount of the coloring material is relatively increased since a coloring pigment that is lack in light blocking properties is mixed. The negative pixel define layer (PDL) according to one embodiment of the present disclosure may contain a black pigment or black dye as an additional coloring material instead of a coloring material contained in the colorant described above.

Hereinafter, each component will be described in detail.

### I. Composition constituting the pixel defining layer

### (1) Leveling agent

The photosensitive composition of the present disclosure includes a leveling agent not only to improve leveling performance, which prevents stains or spots during application, improves the smoothness and fluidity of the coating film, and prevents color stains or defects, but also to prevent the generation of residues due to non-development.

It is preferable that the leveling agent of the present disclosure does not contain fluorine.

It is preferable that the leveling agent is a silicone-based leveling agent.

It is preferable that the silicone-based compound has a molecular weight of 5,000 g/mol to 15,000 g/mol.

It is more preferable that the silicone-based compound has a molecular weight of 5,000 g/mol to 10,000 g/mol.

It is preferable that the silicone-based compound has a viscosity of 100,000 mm²/s to 500,000 mm²/s.

It is more preferable that the viscosity of the silicone-based compound is 10 mm²/s to 40 mm²/s when measured under 20°C conditions with a mixture of 50% by weight of the silicone-based compound and 50% by weight of propylene glycol methyl ether acetate.

It is more preferable that the viscosity of the mixture of the silicone-based compound is 10 mm²/s to 30 mm²/s.

It is preferable that the silicone-based leveling agent contains a substituent selected from the group consisting of a C₁-C₄₀ alkyl group; a C₁-C₄₀ alkenyl group; a C₁-C₄₀ alkynyl group; a C₁-C₄₀ alkoxy group; a C₆-C₄₀ aryloxy group; a C₁-C₄₀ alkoxycarbonyl group; a carbonyl group; an ether group; an ester group; a carboxyl group; or combinations thereof.

Specific examples of the silicone-based leveling agent may include silicone-based leveling agents commercially available under the names of: EFS-101, EFS-104, EFS-106, EFS-109, EFS-120, EFS-121, EFS-134, EFS-135, EFS-201, EFS-203, EFS-204, EFS-210, EFS-220, EFS-301, EFS-302, EFS-303, EFS-314, EFS-317, EFS-318, EFS-326, EFS-329, EFS-333, EFS-349, EFS-355, EFS-358, EFS-359, EFS-362, EFS-601, EFS-701, EFS-801, RS-55, and RS-56 from DIC Corporation; and BYK-333, BYK-378, BYK-3550, BYK-3751, BYK-3754, etc. from BYK Corporation.

It is preferable that the leveling agent is contained in an amount of 0.01 to 0.5 parts by weight based on 100 parts by weight of the photosensitive resin composition.

When the leveling agent is contained within the above range, the coating uniformity of the photosensitive composition is secured, no staining occurs, and the wetting for the glass substrate is excellent.

In addition, the pixel defining layer formed with the photosensitive composition including the silicone-based leveling agent of the present disclosure has an excellent contact angle and coating film flatness, and a low amount of outgas, so that it may not only have a vivid color when applied to a display, but also increase reliability and lifespan.

### (2) Patterning resin

The patterning resin according to one embodiment of the present disclosure may include an acrylic binder resin, a cardo-based binder resin, or a combination thereof.

The acrylic binder resin is a copolymer of a first ethylenically unsaturated monomer and a second ethylenically unsaturated monomer copolymerizable therewith, and is a resin including one or more acrylic repeating units.

The first ethylenically unsaturated monomer is an ethylenically unsaturated monomer containing one or more carboxyl groups, and specific examples thereof may include acrylic acid, methacrylic acid, maleic acid, itaconic acid, fumaric acid, or combinations thereof. The first ethylenically unsaturated monomer may be contained in an amount of 5 to 50% by weight, for example, 10 to 40% by weight based on the total amount of the acrylic binder resin.

The second ethylenically unsaturated monomer may include aromatic vinyl compounds such as styrene, α-methylstyrene, vinyltoluene, vinylbenzyl methyl ether, *etc.;* unsaturated carboxylic acid ester compounds such as methyl (meth)acrylate, ethyl (meth)acrylate, butyl (meth)acrylate, 2-hydroxyethyl (meth)acrylate, 2-hydroxy butyl (meth)acrylate, benzyl (meth)acrylate, cyclohexyl (meth)acrylate, phenyl (meth)acrylate, *etc.*; unsaturated carboxylic acid amino alkyl ester compounds such as 2-aminoethyl (meth)acrylate, 2-dimethylaminoethyl (meth)acrylate, *etc*.; carboxylic acid vinyl ester compounds such as vinyl acetate, *etc.;* unsaturated carboxylic acid glycidyl ester compounds such as glycidyl (meth)acrylate, *etc*.; vinyl cyanide compounds such as (meth)acrylonitrile, *etc.;* and unsaturated amide compounds such as (meth)acrylamide, *etc.,* and these may be used alone or in mixtures of two or more.

Specific examples of the acrylic binder resin may include a (meth)acrylic acid/benzyl methacrylate copolymer, a (meth)acrylic acid/benzyl methacrylate/styrene copolymer, a (meth)acrylic acid/benzyl methacrylate/2-hydroxyethyl methacrylate copolymer, a (meth)acrylic acid/benzyl methacrylate/styrene/2-hydroxyethyl methacrylate copolymer, *etc.,* but are not limited thereto. These may be used alone or in a mixture of two or more. The acrylic binder resin may have a weight average molecular weight of 3,000 g/mol to 150,000 g/mol, for example, 5,000 g/mol to 50,000 g/mol, for example, 20,000 g/mol to 30,000 g/mol.

The cardo-based resin includes a repeating structure such as Formula 1 below. 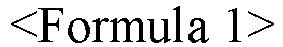 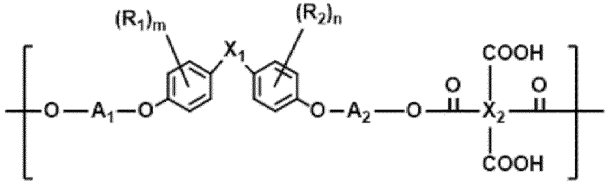 In Formula 1,
1) R₁ and R₂ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
2) R₁ and R₂ can form a ring between neighboring groups,
3) m and n are each independently an integer of 0 to 4,
4) A₁ and A₂ are each independently Formula 2 or Formula 3 below,

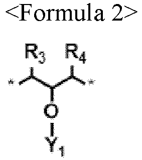

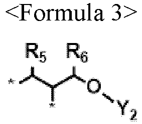

In Formula 2 and Formula 3,
4-1) * indicates a connection part,
4-2) R₃ to R₆ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-3) R₃ to R₆ can form a ring between neighboring groups,
4-4) Y₁ and Y₂ are each independently Formula 6 or Formula 7 below,

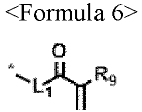

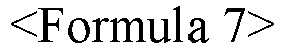

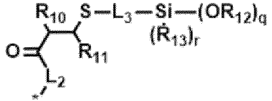

In Formula 6 and Formula 7,
4-4-1) * indicates a binding position,
4-4-2) R₉ is hydrogen or methyl,
4-4-3) R₁₀ to R₁₃ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-4-4) L₁ to L₃ are each independently a single bond; a fluorenylene group; C₂-C₃₀ alkylene; C₆-C₃₀ arylene; C₂-C₃₀ heterocycle; C₁-C₃₀ alkoxylene; C₂-C₃₀ alkyleneoxy; a C₆-C₃₀ aryloxy group; or a C₂-C₃₀ polyethyleneoxy group,
4-4-5) q and r are each independently an integer of 0 to 3; with the proviso that q+r = 3, and
5) the ratio of A₁ and A₂ in the polymer chain of the resin including a repeating unit represented by Formula 1 is 9:1 to 1:9,
6) X₁ is a single bond; O; CO; SO₂; CR'R"; SiR'R"; Formula 4 below; or Formula 5,
6-1) R' and R" are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-2) R' and R" can form a ring between adjacent groups,

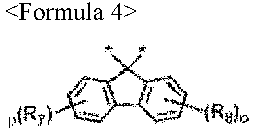

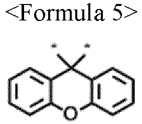

In Formula 4 and Formula 5,
6-3) * indicates a binding position,
6-4) R₇ and R₈ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-5) o and p are each independently an integer of 0 to 4,
7) X₂ is a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenylene group; a carbonyl group; an ether group; or a C₁-C₂₀ alkoxycarbonyl group, and
8) R', R", X₂, L₁ to L₃, R₁ to Rs, and R₁₀ to R₁₃ may each be further substituted with one or more substituents selected from the group consisting of deuterium; a halogen; a silane group substituted or unsubstituted with a C₁-C₃₀ alkyl group or C₆-C₃₀ aryl group; a siloxane group; a boron group; a germanium group; a cyano group; an amino group; a nitro group; a C₁-C₃₀ alkylthio group; a C₁-C₃₀ alkoxy group; a C₆-C₃₀ arylalkoxy group; a C₁-C₃₀ alkyl group; a C₂-C₃₀ alkenyl group; a C₂-C₃₀ alkynyl group; a C₆-C₃₀ aryl group; a C₆-C₃₀ aryl group substituted with deuterium; a fluorenyl group; a C₂-C₃₀ heterocyclic group containing at least one heteroatom selected from the group consisting of O, N, S, Si, and P; a C₃-C₃₀ alicyclic group; a C₇-C₃₀ arylalkyl group; a C₈-C₃₀ arylalkenyl group; and combinations thereof, or may form a ring between adjacent substituents.

When R', R", X₂, L₁ to L₃, R₁ to Rs, and R₁₀ to R₁₃ are an aryl group, they may preferably be a C₆-C₃₀ aryl group, and more preferably a C₆-C₁₈ aryl group, for example, phenyl, biphenyl, naphthyl, terphenyl, *etc.*

When R', R", X₂, L₁ to L₃, R₁ to Rs, and R₁₀ to R₁₃ are a heterocyclic group, they may preferably be a C₂-C₃₀ heterocyclic group, and more preferably a C₂-C₁₈ heterocyclic group, for example, dibenzofuran, dibenzothiophene, naphthobenzothiophene, naphthobenzofuran, *etc.*

When R', R", R₁ to Rs, and R₁₀ to R₁₃ are a fluorenyl group, they may preferably be 9,9-dimethyl-9H-fluorene, 9,9-diphenyl-9H-fluorenyl group, 9,9'-spirobifluorene, *etc.*

When L₁ to L₃ are an arylene group, they may preferably be a C₆-C₃₀ arylene group, and more preferably a C₆-C₁₈ arylene group, for example, phenyl, biphenyl, naphthyl, terphenyl, *etc.*

When R', R", X₂, R₁ to Rs, and R₁₀ to R₁₃ are an alkyl group, they may preferably be a C₁-C₁₀ alkyl group, for example, methyl, t-butyl, *etc.*

When R', R", X₂, R₁ to Rs, and R₁₀ to R₁₃ are an alkoxyl group, they may preferably be a C₁-C₂₀ alkoxyl group, and more preferably a C₁-C₁₀ alkoxyl group, for example, methoxy, t-butoxy, *etc.*

Rings formed by binding between neighboring groups of R', R", X₂, L₁ to L₃, R₁ to Rs, and R₁₀ to R₁₃ may be a C₆-C₃₀ aromatic ring; a fluorenyl group; a C₂-C₆₀ heterocyclic group containing at least one heteroatom of O, N, S, Si, and P; or a C₃₋C₆₀ alicyclic group, and for example, when the neighboring groups bind with each other to form an aromatic ring, preferably, a C₆-C₂₀ aromatic ring, and more preferably a C₆-₁₄ aromatic ring, for example, benzene, naphthalene, phenanthrene, *etc.* may be formed.

The cardo-based resin may be prepared by mixing two or more of, for example, fluorene-containing compounds such as 9,9-*bis*(4-oxiranylmethoxyphenyl)fluorene, *etc.;* anhydride compounds such as a benzene tetracarboxylic acid dianhydride, a naphthalene tetracarboxylic acid dianhydride, a biphenyltetracarboxylic acid dianhydride, a benzophenonetetracarboxylic acid dianhydride, a pyromellitic acid dianhydride, a cyclobutanetetracarboxylic acid dianhydride, a perylenetetracarboxylic acid dianhydride, a tetrahydrofurantetracarboxylic acid dianhydride, a tetrahydrophthalic acid anhydride, *etc.;* glycol compounds such as ethylene glycol, propylene glycol, polyethylene glycol, *etc.;* alcohol compounds such as methanol, ethanol, propanol, n-butanol, cyclohexanol, benzyl alcohol, *etc.;* solvent compounds such as propylene glycol methyl ether acetate (PGMEA), N-methylpyrrolidone, *etc.;* phosphorus compounds such as triphenylphosphine, *etc.;* and amine or ammonium salt compounds such as tetramethylammonium chloride, tetraethylammonium bromide, benzyldiethylamine, triethylamine, tributylamine, benzyltriethylammonium chloride, *etc.*

The cardo-based resin may have a weight average molecular weight of 1,000 g/mol to 100,000 g/mol, preferably 1,000 to 50,000 g/mol, and more preferably 1,000 g/mol to 30,000 g/mol. When the weight average molecular weight of the resin is within the above-described range, the pattern formation is well performed without residue during the preparation of a light blocking layer, there is no loss of film thickness during development, and a good pattern may be obtained. The resin may be contained in an amount of 1 to 30% by weight, and more preferably 3 to 20% by weight based on the total amount of the photosensitive resin composition. When the resin is contained within the above-described range, excellent sensitivity, developing properties, and adhesiveness (adhesion) can be obtained.

### (3) Reactive unsaturated compound

A reactive unsaturated compound that is absolutely necessary for negative patterns may form a pattern having excellent heat resistance, light resistance, and chemical resistance by causing sufficient polymerization during exposure in the pattern forming process by having an ethylenically unsaturated double bond.

Specific examples of the reactive unsaturated compound may include ethylene glycol diacrylate, ethylene glycol dimethacrylate, diethylene glycol diacrylate, triethylene glycol diacrylate, triethylene glycol dimethacrylate, 1,6-hexanediol diacrylate, 1,6-hexanediol dimethacrylate, pentaerythritol triacrylate, dipentaerythritol pentaacrylate, dipentaerythritol hexaacrylate, bisphenol A epoxy acrylate, ethylene glycol monomethyl ether acrylate, trimethylolpropane triacrylate, tripentaerythritol octaacrylate, *etc.*

Examples of commercially available products of the reactive unsaturated compound are as follows.

Examples of a bifunctional ester of (meth)acrylic acid may include Aronix M-210, M-240, M-6200, *etc.* of Toa Kosei Kagaku Kogyo Co., Ltd, KAYARAD HDDA, HX-220, R-604, *etc.* of Nippon Kayaku Co., Ltd, and V-260, V-312, V-335 HP, *etc.* of Osaka Yuki Kagaku Kogyo Co., Ltd.

Examples of a trifunctional ester of (meth)acrylic acid may include Aronix M-309, M-400, M-405, M-450, M-7100, M-8030, M-8060, *etc.* of Toa Kosei Kagaku Kogyo Co., Ltd, KAYARAD TMPTA, DPCA-20, DPCA-60, DPCA-120, *etc.* of Nippon Kayaku Co., Ltd, and V-295, V-300, V-360, *etc.* of Osaka Yuki Kagaku Kogyo Co., Ltd.

The above products may be used alone or used together in combinations of two or more.

The reactive unsaturated compound may be used after being treated with an acid anhydride so as to impart more excellent developing properties. The reactive unsaturated compound may be contained in an amount of 1 to 40% by weight, for example, 1 to 20% by weight based on the total amount of the photosensitive resin composition. When the reactive unsaturated compound is contained within the above-described range, sufficient curing occurs during exposure in the pattern forming process so that reliability is excellent, heat resistance, light resistance, and chemical resistance of the pattern are excellent, and resolution and adhesion are also excellent.

### (4) Photoinitiator

A photoradical initiator should be used in order to implement a negative pattern with photolithography. The photoinitiator is a photoinitiator which has a molar absorption coefficient of 10,000 L/mol·cm or more in the region of 330 to 380 nm and of which a 5% by weight loss occurs at 270°C or lower. Here, the molar extinction coefficient may be calculated by Beer-Lambert Law. In addition, the weight loss was measured while raising the temperature to 300°C at a rate of 5°C per minute under a nitrogen atmosphere using TGA.

The photoinitiator is an initiator generally used in photosensitive resin compositions, and examples thereof may include an acetophenone-based compound, a benzophenone-based compound, a thioxanthone-based compound, a benzoin-based compound, a triazine-based compound, an oxime-based compound, or mixtures thereof.

Examples of the acetophenone-based compound may include 2,2'-diethoxy acetophenone, 2,2'-dibutoxy acetophenone, 2-hydroxy-2-methylpropiophenone, *p-t-*butyltrichloro acetophenone, *p*-*t*-butyldichloro acetophenone, 4-chloro acetophenone, 2,2'-dichloro-4-phenoxy acetophenone, 2-methyl-1-(4-(methylthio)phenyl)-2-morpholinopropan-1-one, 2-benzyl-2-dimethylamino-1-(4-morpholinophenyl)-butan-1-one, *etc.*

Examples of the benzophenone-based compound may include benzophenone, benzoyl benzoate, methyl benzoyl benzoate, 4-phenyl benzophenone, hydroxy benzophenone, acrylated benzophenone, 4,4'-*bis*(dimethylamino)benzophenone, 4,4'-*bis*(diethylamino)benzophenone, 4,4'-dimethylaminobenzophenone, 4,4'-dichlorobenzophenone, 3,3'-dimethyl-2-methoxybenzophenone, *etc.*

Examples of the thioxanthone-based compound may include thioxanthone, 2-chlorothioxanthone, 2-methylthioxanthone, isopropyl thioxanthone, 2,4-diethyl thioxanthone, 2,4-diisopropyl thioxanthone, 2-chlorothioxanthone, *etc.*

Examples of the benzoin-based compound may include benzoin, benzoin methyl ether, benzoin ethyl ether, benzoin isopropyl ether, benzoin isobutyl ether, benzyldimethyl ketal, *etc.*

Examples of the triazine-based compound may include 2,4,6-trichloro-s-triazine, 2-phenyl 4,6-*bis*(trichloromethyl)-*s*-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-*bis*(trichloromethyl)-*s*-triazine, 2-(p-tolyl)-4,6-bis(trichloromethyl)-s-triazine, 2-biphenyl 4,6-*bis*(trichloromethyl)-*s*-triazine, bis(trichloromethyl)-6-styryl-s-triazine, 2-(naphtho-1-yl)-4,6-*bis*(trichloromethyl)-*s*-triazine, 2-(4-methoxy-naphtho-l-yl)-4,6-*s*(trichloromethyl)-*s-*triazine, 2-4-trichloromethyl(piperonyl)-6-triazine, 2-4-trichloromethyl(4'-methoxystyryl)-6-triazine, *etc.*

Examples of the oxime-based compound may include 2-(o-benzoyloxime)-1-[4-(phenylthio)phenyl]-1,2-octanedione, 1-(o-acetyloxime)-1-[9-ethyl-6-(2-methylbenzoyl)-9H-carbazol-3-yl]ethanone, (E)-1(((3-cyclopentyl-1-(9-ethyl-6-(2-methylbenzoyl)-9H-carbazol-3-yl)propylidene)amino)oxy)ethan-1-one (PBG-304, Trony), etc.

The photoinitiator may include carbazole-based compounds, diketone-based compounds, sulfonium borate-based compounds, diazo-based compounds, imidazole-based compounds, non-imidazole-based compounds, etc. in addition to the above compounds.

The photoinitiator may include a peroxide-based compound, an azobis-based compound, *etc.* as radical polymerization initiators.

Examples of the peroxide-based compound may include ketone peroxides such as methyl ethyl ketone peroxide, methyl isobutyl ketone peroxide, cyclohexanone peroxide, methylcyclohexanone peroxide, acetylacetone peroxide, *etc.;* diacyl peroxides such as isobutyryl peroxide, 2,4-dichlorobenzoyl peroxide, o-methylbenzoyl peroxide, *bis*-3,5,5-trimethylhexanoyl peroxide, *etc.;* hydroperoxides such as 2,4,4,-trimethylpentyl-2-hydroperoxide, diisopropylbenzene hydroperoxide, cumene hydroperoxide, t-butyl hydroperoxide, *etc.;* dialkyl peroxides such as dicumyl peroxide, 2,5-dimethyl-2,5-di(*t-*butylperoxy)hexane, 1,3-*bis*(t-butyloxyisopropyl)benzene, *t*-butylperoxyvalerate n-butyl ester, *etc.;* alkyl peresters such as 2,4,4-trimethylpentyl peroxyphenoxyacetate, α-cumyl peroxyneodecanoate, *t*-butyl peroxybenzoate, di-t-butyl peroxytrimethyl adipate, *etc.;* and percarbonates such as di-3-methoxybutyl peroxydicarbonate, di-2-ethylhexyl peroxydicarbonate, *bis*-4-*t*-butylcyclohexyl peroxydicarbonate, diisopropyl peroxydicarbonate, acetylcyclohexylsulfonyl peroxide, *t*-butyl peroxyaryl carbonate, *etc.*

Examples of the azobis-based compound may include 1,1'-azobiscyclohexan-1-carbonitrile, 2,2'-azobis(2,4-dimethylvaleronitrile), 2,2,-azobis(methylisobutyrate), 2,2'-azobis(4-methoxy-2,4-dimethylvaleronitrile), α,α'-azobis(isobutylnitrile), 4,4'-azobis(4-cyanovaleric acid), *etc.*

The photoinitiator may be used together with a photosensitizer that causes a chemical reaction by absorbing light and thus becoming an excited state and then transferring the energy of light. Examples of the photosensitizer may include tetraethylene glycol bis-3-mercaptopropionate, pentaerythritol tetrakis-3-mercaptopropionate, dipentaerythritol tetrakis-3-mercaptopropionate, etc.

The photoinitiator may be contained in an amount of 0.01 to 10% by weight, for example, 0.1 to 5% by weight based on the total amount of the photosensitive composition. When the photoinitiator is contained within the above-described range, curing occurs sufficiently during exposure in the pattern forming process so that excellent reliability may be obtained, heat resistance, light resistance, and chemical resistance of the pattern are excellent, resolution and adhesion are also excellent, and a decrease in transmittance due to an unreacted initiator may be prevented.

### (5) Colorant

All of organic and inorganic pigments and dyes can be used as the colorant.

The colorant may include a red pigment, a green pigment, a blue pigment, a yellow pigment, a black pigment, *etc.*

Examples of the red pigment may include C.I. Red Pigment 254, C.I. Red Pigment 255, C.I. Red Pigment 264, C.I. Red Pigment 270, C.I. Red Pigment 272, C.I. Red Pigment 177, C.I. Red Pigment 89, *etc.*

Examples of the green pigment may include halogen-substituted copper phthalocyanine pigments such as C.I. Green Pigment 36, C.I. Green Pigment 7, *etc.*

Examples of the blue pigment may include copper phthalocyanine pigments such as C.I. Blue Pigment 15:6, C.I. Blue Pigment 15, C.I. Blue Pigment 15: 1, C.I. Blue Pigment 15:2, C.I. Blue Pigment 15:3, C.I. Blue Pigment 15:4, C.I. Blue Pigment 15:5, C.I. Blue Pigment 16, *etc.*

Examples of the yellow pigment may include isoindoline-based pigments such as C.I. Yellow Pigment 139, *etc.,* quinophthalone-based pigments such as C.I. Yellow Pigment 138, *etc.,* and nickel complex pigments such as C.I. Yellow Pigment 150, *etc.*

Examples of the black pigment may include, for example, lactam black, aniline black, perylene black, titanium black, carbon black, *etc.*

In addition, the colorant in the photosensitive resin composition according to the embodiment may include pigments, dyes, or combinations thereof. For example, the dyes may include phthalocyanine-based compounds.

The pigments and dyes may be used alone or in a mixture of two or more, but are not limited to examples thereof.

Among them, the black pigment may be used in order to effectively perform light blocking of the light blocking layer. When the black pigment is used, it may be used together with color correcting agents such as anthraquinone-based pigments, perylene-based pigments, phthalocyanine-based pigments, azo-based pigments, *etc.*

In order to disperse the pigment in the photosensitive resin composition, a dispersant may be used together. Specifically, the pigment may be surface-treated with a dispersant in advance and used, or a dispersant may be added together with the pigment and used during preparation of the photosensitive resin composition.

The dispersant may include a nonionic dispersant, an anionic dispersant, a cationic dispersant, *etc.* Specific examples of the dispersant may include polyalkylene glycol and an ester thereof, polyoxyalkylene, a polyhydric alcohol ester alkylene oxide adduct, an alcohol alkylene oxide adduct, a sulfonic acid ester, a sulfonic acid salt, a carboxylic acid ester, a carboxylic acid salt, an alkylamide alkylene oxide adduct, alkyl amine, *etc.,* and these may be used alone or in mixtures of two or more.

Examples of commercially available products of the dispersant include DISPERBYK-101, DISPERBYK-130, DISPERBYK-140, DISPERBYK-160, DISPERBYK-161, DISPERBYK-162, DISPERBYK-163, DISPERBYK-164, DISPERBYK-165, DISPERBYK-166, DISPERBYK-170, DISPERBYK-171, DISPERBYK-182, DISPERBYK-2000, DISPERBYK-2001, *etc.* from BYK; EFKA-47, EFKA-47EA, EFKA-48, EFKA-49, EFKA-100, EFKA-400, EFKA-450, *etc.* from EFKA Chemical; Solsperse 5000, Solsperse 12000, Solsperse 13240, Solsperse 13940, Solsperse 17000, Solsperse 20000, Solsperse 24000GR, Solsperse 27000, Solsperse 28000, *etc.* from Zeneka; or PB711, PB821, *etc.* from Ajinomoto.

The dispersant may be contained in an amount of 0.1 to 15% by weight based on the total amount of the photosensitive resin composition. When the dispersant is contained within the above-described range, stability, developing properties, and patternability of the composition are excellent when preparing the light blocking layer due to excellent dispersibility of the composition.

The pigment may be pretreated using a water-soluble inorganic salt and a wetting agent and used. When the pigment is pretreated and used as described above, the average particle diameter of the pigment may be refined.

The pretreatment may be performed through a step of kneading the pigment together with a water-soluble inorganic salt and a wetting agent, and a step of filtering and washing the pigment obtained in the kneading step.

The kneading may be performed at a temperature of 40°C to 100°C, and the filtration and washing may be performed by washing the inorganic salt using water, *etc.* and then performing filtration.

Examples of the water-soluble inorganic salt may include sodium chloride, potassium chloride, *etc.,* but are not limited thereto.

The wetting agent serves as a medium through which the pigment and the water-soluble inorganic salt may be uniformly mixed to pulverize the pigment easily, and examples of the wetting agent may include alkylene glycol monoalkyl ethers such as ethylene glycol monoethyl ether, propylene glycol monomethyl ether, diethylene glycol monomethyl ether, *etc.;* and alcohols such as ethanol, isopropanol, butanol, hexanol, cyclohexanol, ethylene glycol, diethylene glycol, polyethylene glycol, glycerin polyethylene glycol, *etc.,* and these may be used alone or in mixtures of two or more.

The pigment that has gone through the kneading step may have an average particle diameter of 20 nm to 110 nm. When the average particle diameter of the pigment is within the above-described range, a fine pattern may be effectively formed while having excellent heat resistance and light resistance.

The pigment may be contained in an amount of 1 to 40% by weight, more specifically 2 to 30% by weight based on the total amount of the photosensitive resin composition. When the pigment is contained within the above-described range, the color reproduction rate is excellent, and the curability and adhesion of the pattern are excellent.

### (6) Solvent

The solvent may include materials which are compatible with the cardo-based resin, the reactive unsaturated compound, the pigment, the cardo-based compound, and the initiator, but do not react therewith.

Examples of the solvent include alcohols such as methanol, ethanol, *etc.;* ethers such as dichloroethyl ether, n-butyl ether, diisoamyl ether, methylphenyl ether, tetrahydrofuran, *etc*.; glycol ethers such as ethylene glycol monomethyl ether, ethylene glycol monoethyl ether, *etc.;* cellosolve acetates such as methyl cellosolve acetate, ethyl cellosolve acetate, diethyl cellosolve acetate, *etc.;* carbitols such as methylethyl carbitol, diethyl carbitol, diethylene glycol monomethyl ether, diethylene glycol monoethyl ether, diethylene glycol dimethyl ether, diethylene glycol methyl ethyl ether, diethylene glycol diethyl ether, *etc.;* propylene glycol alkyl ether acetates such as propylene glycol methyl ether acetate (PGMEA), propylene glycol propyl ether acetate, *etc*.; aromatic hydrocarbons such as toluene, xylene, *etc.;* ketones such as methyl ethyl ketone, cyclohexanone, 4-hydroxy-4-methyl-2-pentanone, methyl-n-propyl ketone, methyl-n-butyl ketone, methyl-n-amyl ketone, 2-heptanone, *etc*.; saturated aliphatic monocarboxylic acid alkyl esters such as ethyl acetate, n-butyl acetate, isobutyl acetate, *etc.;* lactic acid esters such as methyl lactate, ethyl lactate, *etc.;* oxyacetic acid alkyl esters such as methyl oxyacetate, ethyl oxyacetate, butyl oxyacetate, *etc*.; alkoxy acetate alkyl esters such as methoxy methyl acetate, methoxy ethyl acetate, methoxy butyl acetate, ethoxy methyl acetate, ethoxy ethyl acetate, *etc*.; 3-oxypropionic acid alkyl esters such as 3-oxy methyl propionate, 3-oxy ethyl propionate, *etc.*; 3-alkoxy propionic acid alkyl esters such as 3-methoxy methyl propionate, 3-methoxy ethyl propionate, 3-ethoxy ethyl propionate, 3-ethoxy methyl propionate, *etc.*; 2-oxypropionic acid alkyl esters such as methyl 2-oxypropionate, ethyl 2-oxypropionate, propyl 2-oxypropionate, *etc.*; 2-alkoxy propionic acid alkyl esters such as 2-methoxy methyl propionate, 2-methoxy ethyl propionate, 2-ethoxy ethyl propionate, 2-ethoxy methyl propionate, *etc.;* monooxy monocarboxylic acid alkyl esters of 2-oxy-2-methyl propionic acid esters such as 2-oxy-2-methyl methyl propionate, 2-oxy-2-methyl ethyl propionate, *etc.,* and 2-alkoxy-2-methyl propionic acid alkyls such as 2-methoxy-2-methyl methyl propionate, 2-ethoxy-2-methyl ethyl propionate, *etc.;* esters such as 2-hydroxyethyl propionate, 2-hydroxy-2-methyl ethyl propionate, ethyl hydroxyacetate, 2-hydroxy-3-methyl methyl butanoate, *etc.;* and ketonic acid esters such as ethyl pyruvate, *etc.*

Further, high-boiling point solvents such as *N*-methylformamide, *N,N-*dimethylformamide, *N*-methylformanilide, *N*-methylacetamide, *N*,*N*-dimethylacetamide, *N-*methylpyrrolidone, dimethyl sulfoxide, benzyl ethyl ether, dihexyl ether, acetylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, and phenyl cellosolve acetate may also be used.

Considering compatibility and reactivity, glycol ethers such as ethylene glycol monoethyl ether, *etc.;* ethylene glycol alkyl ether acetates such as ethyl cellosolve acetate, *etc.;* esters such as ethyl 2-hydroxypropionate, *etc.;* carbitols such as diethylene glycol monomethyl ether, *etc.*); and propylene glycol alkyl ether acetates such as propylene glycol methyl ether acetate, propylene glycol propyl ether acetate, *etc.* among the above solvents may be used .

The solvent may be contained as a balance amount based on the total amount of the photosensitive resin composition, and specifically in an amount of 40 to 90% by weight. When the solvent is contained within the above-described range, the processability when preparing the pattern layer is excellent as the photosensitive resin composition has an appropriate viscosity.

### II. Preparation process of pixel defining layer

### (1) Application and coating step

The photosensitive composition is a low viscosity liquid sample, and a spin coater or slit coater is used to coat the substrate with a certain thickness after applying the photosensitive composition on the substrate. The spin coater has an advantage in that the flatness deviation in the area decreases although the thickness decreases as the rotation speed increases, and the slit coater is preferable to the spin coater for coating a large-area substrate. The solvent remaining after coating causes the surface to have fluidity, which results in a disadvantage of poor flatness, and to overcome this, vacuum chamber dry (VCD) is used to remove some of the solvent, thereby lowering the fluidity on the surface.

### (2) Pre-bake step

This is a process of heating the coated substrate with a hot plate or oven at a certain temperature and time to remove some of the solvent contained in the coating film. If the surface or deep part of the coating film is not dry, contamination of the photomask occurs during exposure in the next process, and curing is not done well in the exposed portion when irradiated with ultraviolet light, and due to under-curing, the pattern is not formed and is removed in the development process.

### (3) Exposure step

This is a process of curing the formed film by irradiating the photomask having the pattern formed thereon after the prebake process is completed with an active line (ultraviolet ray). The types of lamps that generate the active line include LED lamps or metal (mercury) lamps, the wavelengths include g-line (436 nm), h-line (405 nm), i-line (365 nm), and deep UV (<260 nm), and they can be used individually or in combination.

### (4) Development step

In the exposure step, the exposed portion and the non-exposed portion are divided by the photomask when the active line is irradiated, and in the case of the positive type, the exposed portion is melted by the developer, and the non-exposed portion resists the developer and a pattern remains. In the case of the negative type, the exposed portion is cured and has resistance to the developer, and the non-exposed portion is developed. The black pixel defining layer (Black PDL) prepared with the composition including the colorant of the present disclosure is the negative type and is divided into the exposed portion (cured) and the non-exposed portion (developed), and a pattern is formed.

### (5) Post-heat treatment step

This is a process of removing the remaining solvent and fume by applying heat to the developed substrate at a high temperature of 210°C to 300°C. If the solvent and fume are not completely removed during the relevant process, outgas is generated during the process after post-heat treatment, which affects the device and causes dark spots or pixel shrinkage to be affected due to this.

In another embodiment, the pixel separation part of the organic light-emitting device electrode can be patterned by using the photosensitive resin composition described above.

Hereinafter, Synthesis Examples and Examples according to the present disclosure will be described in detail, but Synthesis Examples and Examples of the present disclosure are not limited thereto.

### (Preparation of black photosensitive composition)

### Synthesis Example 1: (Preparation of 9,9-bis[4-(glycidyloxy)phenyl]fluorene of Formula 8)

25 g of 9,9-bis[4-(glycidyloxy)phenyl]fluorene of Formula 8 below was obtained by adding 20 g of 9,9'-bisphenol fluorene (Sigma Aldrich), 8.67 g of glycidyl chloride (Sigma Aldrich), and 30 g of anhydrous potassium carbonate together with 100 mL of dimethylformamide into a 300 mL 3-neck round-bottom flask having a distillation tube installed thereon, raising the temperature to 80°C to perform reaction for 4 hours, lowering the temperature to 25°C to filter the reaction solution, adding the filtrate dropwise to 1,000 mL of water while performing stirring, filtering the precipitated powder, washing the filtered precipitated powder with water, and drying it under reduced pressure at 40°C. As a result of purity analysis of the obtained powder by HPLC, a purity of 98% was shown.

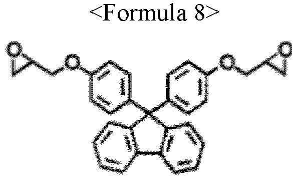

### Synthesis Example 2: Preparation of cardo-based binder resin

25g (54 mmol) of Compound 1 obtained in Synthesis Example 1, 8 g of acrylic acid (Daejung Chemicals & Metals Co., Ltd.), 0.2 g of benzyltriethylammonium chloride (Daejung Chemicals & Metals Co., Ltd.), and 0.2 g of hydroquinone (Daejung Chemicals & Metals Co., Ltd.) together with 52 g of propylene glycol methyl ether acetate (Sigma Aldrich) were added into a 300 mL 3-neck round-bottom flask having a distillation tube installed thereon, and stirring was performed at 110°C for 6 hours. After completion of the reaction, 8 g of biphenyltetracarboxylic dianhydride (Mitsubishi Gas) and 1.8 g of tetrahydrophthalic acid (Sigma Aldrich) were added thereto, and then stirring was performed again at 1 10°C for 6 hours. After completion of the reaction, a cardo-based binder resin having a molecular weight of 4,580 and a solid content of 45% could be obtained as a result of recovering the reaction solution and performing analysis.

### Preparation Example 1: Preparation of black pigment dispersion

A dispersion could be obtained by dispersing 15 g of Irgaphor Black S 100 CF (black pigment/BASF), 8.5 g of Disperbyk 163 (BYK), and 6.5 g of SR-3613 (SMS) together with 70 g of propylene glycol methyl ether acetate for 8 hours using a paint shaker (Asada) of 100 g of zirconia beads with a diameter of 0.5 mm (Toray).

Photosensitive composition solutions were prepared with the compositions as shown in Table 1 below.

Specifically, after the initiator was dissolved in a solvent, and then stirring was performed at room temperature, and then a binder resin and a polymerizable compound were added thereto to perform stirring at room temperature. Subsequently, a colorant and other additives were added to the obtained reactants, and stirring was performed at room temperature. Subsequently, the reaction products were filtered three times to remove impurities, thereby preparing photosensitive resin compositions.

**[Table 1]**

| | **Composi tion 1-1** | **Composi tion 1-2** | **Composi tion 1-3** | **Composi tion 1-4** | **Composi tion 1-5** | **Composi tion 1-6** |
|---|---|---|---|---|---|---|
| Black pigment dispersion (Preparation Example 1) | 23 | 23 | 23 | 23 | 23 | 23 |
| Cardo binder resin (Synthesis Example 2) | 15 | 15 | 15 | 10 | 15 | 15 |
| Acrylic resin | - | - | - | 5 | - | - |
| Reactive unsaturated compound | 12.5 | 12.5 | 12.5 | 12.5 | 12.5 | 12.5 |
| Photoinitiator | 0.5 | 0.5 | 0.5 | 0.5 | 0.5 | 0.5 |
| BYK-333 (Silicone-based leveling agent, BYK) | 0.05 | | | | | |
| EFS-135 (Silicone-based leveling agent, DIC) | | 0.10 | | | | |
| EFS-301 (Silicone-based leveling agent, DIC) | | | 0.20 | | | |
| EFS-701 (Silicone-based leveling agent, DIC) | | | | 0.05 | | |
| EFS-801 (Silicone-based leveling agent, DIC) | | | | | 0.05 | |
| F-562 (Fluorine leveling agent, DIC) | | | | | | 0.05 |
| Solvent | 48.95 | 48.9 | 48.8 | 48.95 | 48.95 | 48.95 |

SR-3100 (SMS, a resin containing double bonds with an average molecular weight of 6,000 to 8,000) was used as the acrylic resin, Miraemer M600 (Miwon Specialty Chemical Co., Ltd.) was used as the reactive unsaturated compound, PBG-304 (Trony) was used as the photoinitiator, and propylene glycol methyl ether acetate was used as the solvent.

The silicone leveling agents used in Compositions 1-1 to 1-5 above have molecular weights of 5,000 g/mol to 15,000 g/mol.

The molecular weights are measured after dissolving 100 mg of the sample to be measured in 10 g of tetrahydrofuran (THF) using Agilent GPC (1260 Infinity). The GPC column was analyzed using a combination of Shodex GPC-802, 803, and 804, and measurement was performed using the RI detector at a speed of 1 ml/min for 1 hour.

The viscosities of the silicone leveling agents themselves are 100,000 mm²/s to 500,000 mm²/s, and the viscosity of the mixture of 50% by weight of the silicone-based leveling agent and 50% by weight of propylene glycol methyl ether acetate, which has been measured at 20°C, is 10 mm²/s to 40 mm²/s.

The viscosity is measured at 20±3°C for 1 minute using a Brookfield viscometer (LVDVNX-CP) by placing a 1 ml sample in a sample cup. The spindle used for the measurement was (Z-40), and measurement was performed in an analysis rpm range of 10 to 15.

The method for preparing a negative pixel defining layer (PDL) using the photosensitive composition is as follows.

### (1) Application and coating step

A coating film is formed by removing a portion of the solvent using vacuum chamber dry (VCD) after applying a photosensitive composition to a certain thickness onto a substrate on which a washed 10 cm* 10 cm metal has been deposited using a spin coater. The photosensitive composition is coated to a coating thickness of 2.0 micrometers to 1.7 micrometers after VCD to form the film.

### (2) Prebake step

In order to remove the solvent contained in the obtained coating film, the coating film is heated on a hot plate at 90°C to 120°C for 100 seconds to 150 seconds. A certain amount of the solvent in the relevant process may be removed, thereby reducing contamination of a pixel-shaped mask and forming a clean type pattern during the exposure step of the next process.

### (3) Exposure step

After interposing a pixel-shaped mask to form a pattern required for the obtained coating film and obtain a constant thickness, a pattern may be formed by irradiating an active ray of 190 nm to 600 nm, preferably a light source of a metal or LED lamp having a ghi-line through an exposure machine. The exposure amount irradiated for pattern formation is an active line of 80 mJ/cm² to 110 mJ/cm², and it is a negative-type photoresist material to be formed.

### (4) Development step

Following the exposure step, after development is performed by a method of dipping the coating film in tetramethylammonium hydroxide (TMAH) as a 2.38 wt% developer at 23 ± 2°C for a certain period of time (minutes), when washing is performed using ultrapure water (DI water), the non-exposed portion is dissolved and removed, thereby allowing only the exposed portion to remain to form an image pattern, and the coating film has a thickness of 1.70 to 1.90 µm.

### (5) Post-heat treatment step

In order to obtain the image pattern obtained by the above phenomenon, a post-heat treatment (post baking) is performed at 210°C to 300°C for 60 to 120 minutes to completely remove the solvent, harden the pattern to form a film, and then measure the outgas.

### (6) Device reliability evaluation

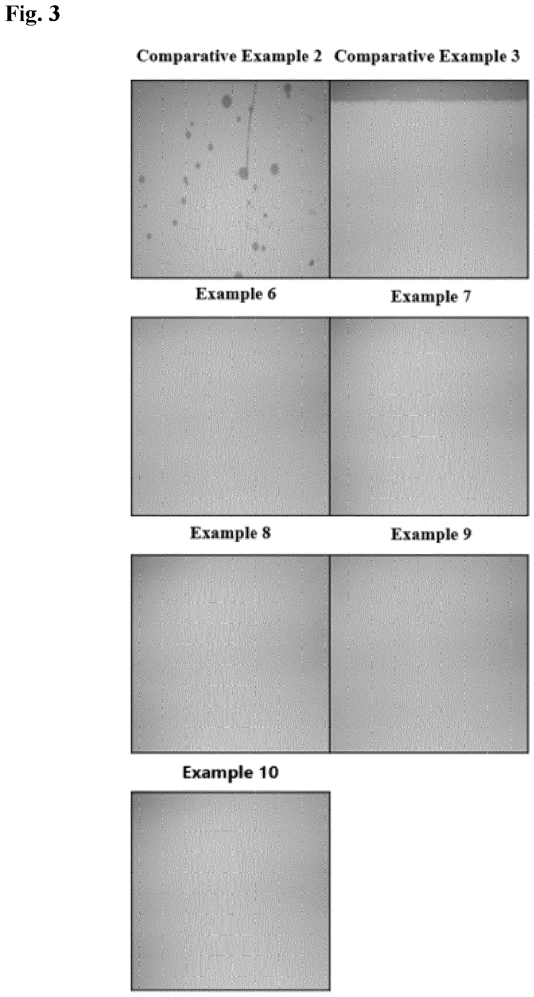

As shown in FIGS. 2 and 3, in order to evaluate the device reliability such as pixel shrinkage and dark spots, an electrode with a thickness of ITO (80 to 120 Å)-Ag (900 to 1,100 Å)-ITO (80 to 120 Å) was formed on a glass surface depending on each condition of the composition, an evaluation substrate was manufactured by forming a pixel definition layer on the electrode using the photosensitive composition of the present disclosure as in the steps (1) to (6), and reliability verification factors were checked.

### (7) Outgas measurement

After forming a pattern on the substrate through the above steps (1), (2), (3), (4), and (5) using the photosensitive composition, the outgas in an area of 10 cm × 10 cm was measured. A film was formed to a coating thickness of 1.45 µm to 1.55 µm after post-heat treatment, and the weight of the 10 cm × 10 cm substrate after coating it with the photosensitive composition on the 10 cm × 10 cm substrate and performing post-heat treatment was 11 to 12 g. The relevant substrate was captured for outgas at 250°C for 30 minutes using JTD-505III of JAI. After measuring toluene black samples (5, 10, and 50 ppm) using QP2020 GC/MS of Shimadzu, a calibration curve was created, and the outgas generation amounts of the captured samples were extrapolated and measured. The samples were compared for each measured outgas detection amount with samples that changed the process conditions such as the development time and temperature in the development step, and the heating temperature and heat treatment time in the post-heat treatment step.

### (8) Contact angle measurement method

Ultra-pure water (DI water) is dropped on the film formed with a thickness of 1.45 µm to 1.55 µm after the above application and coating, exposure, development, and post-heat treatment, and the contact angle with the surface is measured. Equipment for measuring the contact angle used is KRUSS DSA 25 equipment, and ultra-pure water is put into a micro syringe and the contact angle with the interface is measured by dropping 2 microliters thereof. The contact angle is measured as the average of the values on the left and right sides of the water droplet.

**[Table 2]**

| | | Post-heat treatment temperature (°C) | Outgas amount after post-heat treatment (ppm) | Contact angle (°) @ultra-pure water | Residue |
|---|---|---|---|---|---|
| Comparative Example 1 | Composi tion 1-6 | 250 | 15.30 | 87.3 | Absence |
| Comparative Example 2 | Composi tion 1-6 | 180 | 18.25 | 114.0 | Presence |
| Comparative Example 3 | Composi tion 1-6 | 330 | 5.94 | 56.5 | Absence (pixel shrinkag e) |
| Example 1 | Composi tion 1-1 | 210 | 12.57 | 91.5 | Absence |
| Example 2 | Composi tion 1-2 | 210 | 12.84 | 91.3 | Absence |
| Example 3 | Composi tion 1-3 | 210 | 12.66 | 91.5 | Absence |
| Example 4 | Composi tion 1-4 | 210 | 12.30 | 91.0 | Absence |
| Example 5 | Composi tion 1-5 | 210 | 12.21 | 90.6 | Absence |
| Example 6 | Composi tion 1-1 | 250 | 11.01 | 80.2 | Absence |
| Example 7 | Composi tion 1-2 | 250 | 10.97 | 80.4 | Absence |
| Example 8 | Composi tion 1-3 | 250 | 10.99 | 80.9 | Absence |
| Example 9 | Composi tion 1-4 | 250 | 10.76 | 80.1 | Absence |
| Example 10 | Composi tion 1-5 | 250 | 10.65 | 79.7 | Absence |
| Example 11 | Composi tion 1-1 | 270 | 9.79 | 71.9 | Absence |
| Example 12 | Composi tion 1-2 | 270 | 9.62 | 72.6 | Absence |
| Example 13 | Composi tion 1-3 | 270 | 9.81 | 73.6 | Absence |
| Example 14 | Composi tion 1-4 | 270 | 9.76 | 73.0 | Absence |
| Example 15 | Composi tion 1-5 | 270 | 9.70 | 72.8 | Absence |
| Example 16 | Composi tion 1-1 | 300 | 7.94 | 60.5 | Absence |
| Example 17 | Composi tion 1-2 | 300 | 7.16 | 60.9 | Absence |
| Example 18 | Composi tion 1-3 | 300 | 8.16 | 61.3 | Absence |
| Example 19 | Composi tion 1-4 | 300 | 8.01 | 60.1 | Absence |
| Example 20 | Composi tion 1-5 | 300 | 7.91 | 59.8 | Absence |

In Table 2, referring to the results of Comparative Example 1 and Examples 4 to 6, it could be confirmed that the results of the Examples had a lower outgassing amount of 15 ppm or less after the post-heat treatment at the same post-heat treatment temperature. This is judged to be a result of the silicone-based leveling agent mixed with the resin contained in the photosensitive composition having more excellent thermal stability at high temperatures than the fluorine-based leveling agent.

In addition, referring to Table 2 above and FIG. 2, in the case of the Examples in which the post-heat treatment temperature was adjusted in the range of 210°C to 300°C, it could be confirmed that the outgas amount was reduced and the contact angle was included in the range of 60° to 100° compared to the results of Comparative Example 2 in which the post-heat treatment temperature was low, and compared to the results of Comparative Example 3 in which the post-heat treatment temperature was high, it could be confirmed that the outgas amount was at a similar level, but the contact angle was included in the range limited to the present disclosure.

In addition, referring to Table 2 above and FIG. 3, in the case of the Examples in which the pixel defining layer was prepared by applying an appropriate post-heat treatment temperature range of 210°C to 300°C, it was confirmed that since the pixel defining layer residue and pixel shrinkage phenomenon did not occur, excellent reliability could be secured in the device configuration.

On the other hand, when the post-heat treatment temperature was low, less than 210°C as in the result of Comparative Example 2, it could be confirmed that the amount of outgas increased after the post-heat treatment, resulting in dark spots on the device, and when the post-heat treatment temperature was 300°C or higher as in Comparative Example 3, it could be confirmed that the pixel defining layer could not withstand the high temperatures, and the pixel shrinkage phenomenon occurred due to the outgas additionally generated during device operation.

The above description is merely illustrative of the present disclosure, and those skilled in the art to which the present disclosure pertains will be able to make various modifications without departing from the essential characteristics of the present disclosure.

Accordingly, the embodiments disclosed in this specification are for illustrative purposes only and are not intended to limit the present disclosure, and the spirit and scope of the present disclosure are not limited by these embodiments. The scope of protection of the present disclosure should be interpreted in accordance with the claims, and all technologies within the scope equivalent thereto should be interpreted as being included in the scope of rights of the present disclosure.

## Claims

1. A pixel defining layer containing a photosensitive composition comprising a resin; and a leveling agent that does not contain fluorine.

2. The pixel defining layer of claim 1, wherein the leveling agent includes a silicone-based compound.

3. The pixel defining layer of claim 2, wherein the silicone-based compound has a molecular weight of 5,000 g/mol to 15,000 g/mol.

4. The pixel defining layer of claim 2, wherein the silicone-based compound has a viscosity of 100,000 mm²/s to 500,000 mm²/s.

5. The pixel defining layer of claim 2, wherein the silicone-based compound contains a substituent of the group consisting of: a C₁-C₄₀ alkyl group; a C₁-C₄₀ alkenyl group; a C₁-C₄₀ alkynyl group; a C₁-C₄₀ alkoxy group; a C₆-C₄₀ aryloxy group; a C₁-C₂₀ alkoxycarbonyl group; a carbonyl group; an ether group; an ester group; a carboxyl group, or combinations thereof.

6. The pixel defining layer of claim 1, wherein the photosensitive composition includes a leveling agent that does not contain 0.01 to 0.5% by weight of fluorine based on the total amount of the photosensitive composition.

7. The pixel defining layer of claim 1, wherein the resin includes an acrylic binder resin; a cardo-based binder resin; or a combination thereof.

8. The pixel defining layer of claim 1, which is prepared by comprising the step of post-heat treating the photosensitive composition.

9. The pixel defining layer of claim 8, wherein the post-heat treatment step is performed at a temperature of 210°C to 300°C for 30 minutes to 120 minutes.

10. The pixel defining layer of claim 8, which is prepared by further comprising the steps of: applying and coating the photosensitive composition; performing pre-bake; performing exposure; and performing development..

11. The pixel defining layer of claim 1, wherein the photosensitive composition comprises a colorant.

12. The pixel defining layer of claim 1, wherein the photosensitive composition comprises a reactive unsaturated compound.

13. The pixel defining layer of claim 1, wherein the photosensitive composition comprises a photoinitiator.

14. The pixel defining layer of claim 1, wherein the pixel defining layer has a contact angle with the interface of 60° to 100° when 2 to 10 microliters (*µ*ℓ) of water is brought into contact with the surface under temperature conditions of 25±3°C.

15. The pixel defining layer of claim 1, wherein the pixel defining layer after the post-heat treatment step has a thickness of 1.40 µm to 1.60 µm.
